# EUROPEAN PATENT SPECIFICATION

(11) **EP 4 098 466 B1**
(45) Date of publication and mention of the grant of the patent: **12.06.2024**
(21) Application number: 22173477.5
(22) Date of filing: 16.05.2022
(51) Int. Cl.: B60K 16/00, B60L 53/51, H02S 30/20, B60L 8/00, B60L 53/20, H02S 20/30

(54) **VEHICLE HAVING AUTOMATIC SOLAR CHARGING STRUCTURE**
FAHRZEUG, DAS EINE AUTOMATISCHE SOLARLADESTRUKTUR AUFWEIST
VÉHICULE DOTÉ D'UNE STRUCTURE DE CHARGE SOLAIRE AUTOMATIQUE

(30) Priority: 01.06.2021 KR 20210071025
(43) Date of publication of application: 07.12.2022
(73) Proprietor: Kim, Sung Pok, Chungcheongnam-do, 31090 (KR)
(72) Inventor: Kim, Sung Pok, Chungcheongnam-do, 31090 (KR)
(74) Representative: Viering, Jentschura & Partner mbB Patent- und Rechtsanwälte

(56) References cited:
- US-A1- 2002 046 764
- US-A1- 2009 211 621
- US-A1- 2019 181 796

## Description

### BACKGROUND

### 1. Field of the Invention

The present invention relates to a vehicle including an automatic solar charging structure, and more specifically, to a vehicle including an automatic solar charging structure including a configuration capable of effectively accommodating solar energy and a configuration capable of cleanly protecting a solar cell panel.

### 2. Discussion of Related Art

Generally, an electric vehicle moves by electric energy of a storage battery. According to this, general electricity is used to charge an exhausted storage battery of the electric vehicle. The general electricity is used to recharge the storage battery of the electric vehicle to drive the electric vehicle, but there is a problem in that a recharging time is too long for commercialization.

Further, as a storage battery of a diesel (lead-free gasoline) vehicle and a storage battery of an electric vehicle were consumed, it was impossible to recharge the storage batteries as there was no such structure and device to automatically recharge the storage batteries.

Specifically, in the electric vehicle, high battery efficiency or low battery efficiency decisively affects vehicle performance, such as mileage, speed, and the like.

However, a case in which a conventional electric vehicle should be frequently recharged because the mileage is short when a battery mounted in the vehicle is charged once, and a velocity of the vehicle is low because the vehicle should carry a battery having a large capacity to be driven is indicated as the biggest problem.

In addition, since there are no structure and device for charging the electric vehicle while driving or externally stopped, there are many problems for driving the electric vehicle for a long time.

Accordingly, Laid-Open Utility Model No. 2010-0012946 disclosed in the Korean Intellectual Property Office has been published. This is invented so that a solar cell module which converts eco-friendly power, that is, solar energy, to electric energy, is installed on a sunroof for a vehicle, and electric energy is produced to achieve power supply of the vehicle through the solar cell module even when the vehicle is driven.

However, looking at the conventional patent document, since the solar cell module is installed only on the sunroof and the power generated from the above is also very insufficient, and thus the power is used only for lighting devices of the vehicle, in consideration of facility costs, manufacturing costs of the solar cell module, or the like, there was a problem in that efficiency was significantly low.

Further, since the production efficiency of power required to drive a vehicle is low, it is difficult to apply this to the case in which electricity is a main power source, such as an electric vehicle.

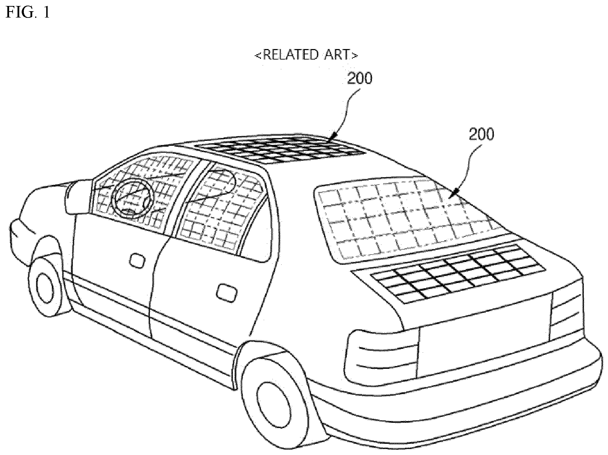

In order to solve these problems, as shown in FIG. 1, a technology capable of storing electricity through sunlight on a roof panel, side and rear glass panels, and a trunk panel of a vehicle even when the vehicle is driven has been developed. However, in the related art shown in FIG. 1, a solar cell panel is always exposed to the outside even in weather in which solar power generation is impossible or in a situation in which the solar power generation is not necessary. Accordingly, in the solar cell panel shown in FIG. 1, for effective solar power generation, the cleanliness of an external surface should be always checked, and the panel has a problem of being easily damaged by an external impact.

Further, the structure shown in FIG. 1 is a structure which should be directly installed on the vehicle, and cannot be applied to other vehicles by separating a configuration including a solar panel. Further, the structure shown in FIG. 1 is a structure that is customized to the size and shape of the vehicle, and has a problem of not being able to be attached to another vehicle having a different size and shape to be used even when separated from the vehicle.

Accordingly, a technology capable of solving the problems according to the above-mentioned related art is necessary.

(Patent Document 1) Korean Registration Patent KR 101801249 B1 (Date of registration: November 20, 2017).

US 2019/0181796 A1 discloses a roof rack assembly and a hood light-blocking fabric assembly, the roof rack assembly comprising: a pair of roof racks coupled to the roof of a vehicle; a photovoltaic generation light-blocking module coupled to be able to move forward/backward along the pair of roof racks and configured to expose/cover the roof and to block sunlight; a light-blocking plate transfer portion for applying a driving force such that the photovoltaic generation light-blocking module moves forward/backward along the pair of roof racks and is unfolded over the roof of the vehicle or is folded; a converter for converting electric energy generated by the photovoltaic generation light-blocking module into power that can be used by the light-blocking plate transfer plate and the vehicle; an accumulator for storing power converted by the converter; and a controller for controlling supply of power by the converter and the accumulator.

US 2009/211621 A1 discloses a removable magnetically attached solar collector sheet system comprising a thin film, organic and printable photovoltaic sheet attached to a flexible magnetic sheet. The system removably attaches to any metal surface magnetically, conforms to that surface, and connects into the power supply of that object, such as homes, vehicles, commercial buildings, light poles, and other industrial applications.

### SUMMARY OF THE INVENTION

The present invention is directed to providing a vehicle including an automatic solar charging structure including a configuration that can effectively accommodate solar energy to efficiently produce electric energy, and cleanly protect a solar cell panel, and thus stably maintain power generation efficiency using the solar energy.

According to an aspect of the present invention, there is provided a vehicle including an automatic solar charging structure including: a solar panel accommodation part mounted on one side surface among outer surfaces of the vehicle to wind and accommodate a solar panel mounting part; the solar panel mounting part having a structure that is inserted into and accommodated in the solar panel accommodation part, or discharged from one side of the solar panel accommodation part, having a structure that is unfolded to be expanded to an area corresponding to one side surface among an outer peripheral surface of the vehicle after being discharged from the solar panel accommodation part, and configured to mount a plurality of solar cell panels to be spaced apart from each other at predetermined intervals on one side surface; the solar cell panels mounted on one side surface of the solar panel mounting part to be spaced apart from each other at the predetermined intervals, and configured to perform solar power generation; and a controller mounted on the solar panel accommodation part, configured to control the operation of the solar panel accommodation part according to a user's intention, and providing electricity acquired from the solar cell panels to the vehicle.

The solar panel accommodation part includes: a first accommodation part mounted on an upper surface of a roof of the vehicle; a second accommodation part mounted on a hood upper surface of the vehicle; a third accommodation part mounted on an upper surface of a rear trunk of the vehicle; fourth accommodation parts mounted on side glass windows of the vehicle; and fifth accommodation parts mounted on side surfaces of the vehicle.

The solar panel mounting part has a structure of which a shape is elastically deformable along the outer surface of the vehicle on which the solar panel accommodation part is mounted.

In one embodiment of the present invention, the solar panel accommodation part may include: a winding roller mounted on one side surface among outer surfaces of the vehicle, and configured to wind the solar panel mounting part around an outer circumferential surface thereof to change an extending length of the solar panel mounting part; and a rotation driving part mounted on the winding roller and configured to rotate the winding roller according to a control signal of the controller.

In one embodiment of the present invention, the solar panel accommodation part may include: a winding housing of a hollow-type cylindrical structure that is mounted on one side surface among the outer surfaces of the vehicle, configured to rotatably mount the winding roller therein, and formed with a discharge port through which the solar panel mounting part accommodated therein enters and exits at one side surface; a housing fixing part having a structure that is mounted on one side surface of the winding housing, and configured to detachably fix the winding housing to the outer surface of the vehicle; the winding roller rotatably mounted in the winding housing, and configured to wind the solar panel mounting part around an outer circumferential surface thereof; a rotation driving part mounted at one side of the winding housing and configured to rotate the winding roller according to a control signal of the controller; a pair of extending rails having a structure that is mounted in a state of being adjacent to the discharge port formed at one side of the solar panel accommodation part and being wound at both side surfaces, and drawn out by a user to extend by a predetermined length in a discharging direction of the solar panel mounting part; and a plurality of detachable fixing parts mounted at one sides of the extending rails to be spaced apart from each other at a predetermined interval, and configured to adsorb and fix the extending rails to the outer surface of the vehicle.

In this case, the solar panel mounting part may include: a pair of extending frames having a wire structure that is wound around outer circumferential surfaces of both end portions of the winding roller, having a structure of which a position is changed along the extending rails, and bound to both end portions of the solar cell panel to fix a position of the solar cell panel; and spacing frames mounted between the pair of extending frames in an integrated structure, and configured to maintain an interval between the pair of extending frames at a predetermined distance.

In one embodiment of the present invention, the fifth accommodation parts of the solar panel accommodation part may be sequentially mounted to be adjacent to each other in an independent form by 1,000 to 1,400 mm along the side surface of the vehicle.

In one embodiment of the present invention, the solar cell panels may be mounted in a form of which portions of both end portions are engaged with each other to overlap each other, and both end portions of the solar cell panels overlapping each other according to the user's intention may be unfolded and sequentially disposed.

In one embodiment of the present invention, the vehicle may include: a sunlight amount detector mounted on the outer surface of the vehicle to detect an amount of sunlight incident thereon in real time, and transmit detected data to the controller; a weather information acquisition part mounted in the vehicle and linked to an Internet network to receive real-time weather information and transmit the real-time weather information to the controller; a position change part mounted on the outer surface of the vehicle and configured to change a position of the solar panel accommodation part; and an angle change part configured to change a mounting angle of the solar cell panels mounted on the solar panel mounting part.

In this case, the controller may control operations of the solar panel accommodation part, the position change part, and the angle change part using the sunlight amount detector and the weather information acquisition part, have a built-in wireless communication module interworking with a user's smart device, and provide an operation state of the solar panel accommodation part and a production state of electricity produced from the solar cell panels to the user's smart device using the wireless communication module.

### BRIEF DESCRIPTION OF THE DRAWINGS

The above and other objects, features and advantages of the present invention will become more apparent to those of ordinary skill in the art by describing in detail exemplary embodiments thereof with reference to the accompanying drawings, in which:
FIG. 1 is a perspective view illustrating a vehicle according to the related art;
FIG. 2 is a front schematic view illustrating a vehicle including an automatic solar charging structure according to one embodiment of the present invention;
FIG. 3 is a perspective view illustrating a solar panel accommodation part, a solar panel mounting part, and a solar cell panel shown in FIG. 2;
FIG. 4 is a front schematic view illustrating a vehicle including an automatic solar charging structure according to another embodiment of the present invention;
FIG. 5 is a front schematic view illustrating a vehicle including an automatic solar charging structure according to still another embodiment of the present invention;
FIG. 6 is a perspective view illustrating a solar panel accommodation part, a solar panel mounting part, and a solar cell panel of a vehicle according to still another embodiment of the present invention;
FIG. 7 is a perspective view illustrating a case in which the configuration shown in FIG. 6 operates; and
FIG. 8 is a control block diagram illustrating a vehicle including an automatic solar charging structure according to still another embodiment of the present invention.

### DETAILED DESCRIPTION OF EXEMPLARY EMBODIMENTS

Hereinafter, preferable embodiments of the present invention will be described in detail with reference to the drawings. Prior to this, terms or words used in the specification and claims should not understood as being limited to conventional or dictionary meanings, but should be understood as meanings and concepts consistent with the technical spirit of the present invention.

Throughout this specification, a case in which a member is said to be located "on" another member includes not only a case in which a member comes into contact with another member but also a case in which another member is present between the two members. Throughout this specification, a case in which a part "includes" a certain component refers to a case in which other components may be further included, rather than excluding other components, unless otherwise disclosed.

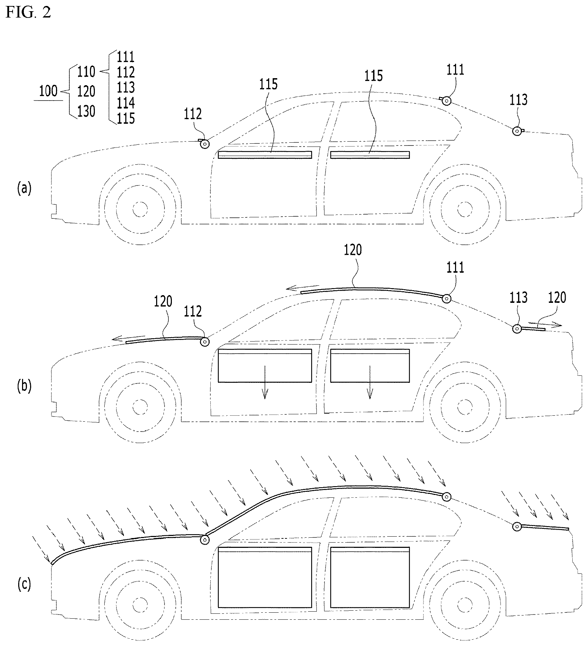

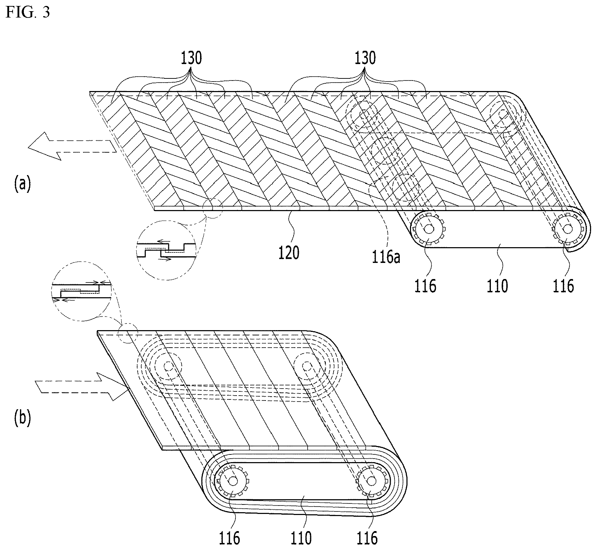

A front schematic view illustrating a vehicle including an automatic solar charging structure according to one embodiment of the present invention is shown in FIG. 2, and a perspective view illustrating a solar panel accommodation part, a solar panel mounting part, and a solar cell panel shown in FIG. 2 is shown in FIG. 3.

Referring to these drawings, according to a vehicle 100 including an automatic solar charging structure according to the embodiment, it is possible to provide a vehicle including an automatic solar charging structure, including a configuration capable of effectively accommodating solar energy to efficiently produce electric energy, and cleanly protecting a solar cell panel to stably maintain power generation efficiency using the solar energy by including a solar panel accommodation part 110, a solar panel mounting part 120, solar cell panels 130, and a controller 140 of specific structures.

Hereinafter, each configuration constituting the vehicle 100 according to the embodiment will be described in detail with reference to the drawings.

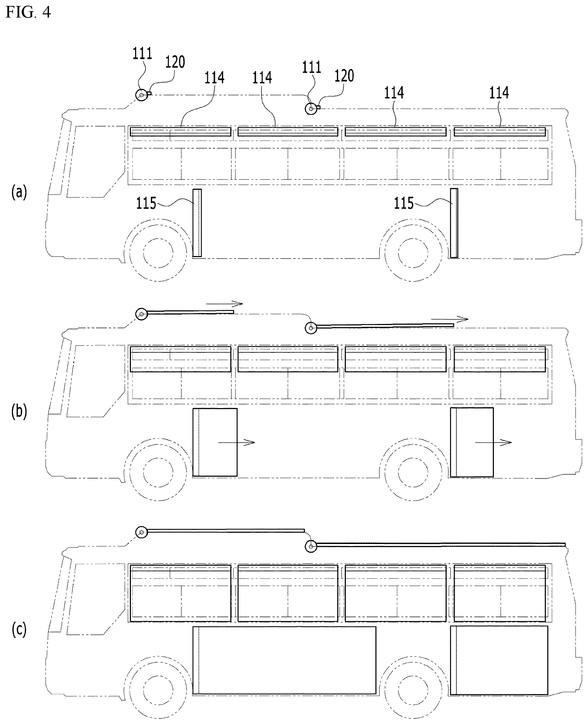

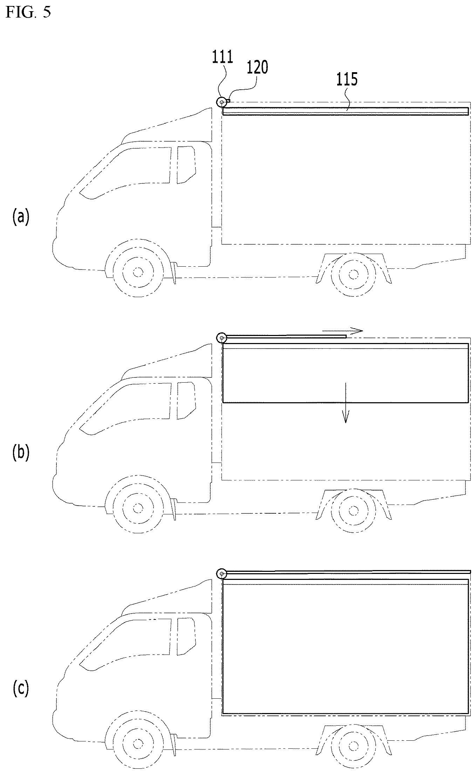

A front schematic view illustrating a vehicle including an automatic solar charging structure according to another embodiment of the present invention is shown in FIG. 4, and a front schematic view illustrating a vehicle including an automatic solar charging structure according to still another embodiment of the present invention is shown in FIG. 5.

Referring to FIGS. 2 to 5, the vehicle 100 according to the embodiment may be a configuration including the solar panel accommodation part 110, the solar panel mounting part 120, the solar cell panels 130, and the controller 140 of specific structures.

Specifically, the solar panel accommodation part 110 may be a configuration mounted on one side surface among outer surfaces of the vehicle to wind and accommodate the solar panel mounting part 120.

In some cases, as shown in FIG. 3, the solar panel accommodation part 110 according to the embodiment may be a configuration which winds and fixes the solar panel mounting part 120 at the outside thereof.

The solar panel mounting part 120 has a structure that is inserted into and accommodated in the solar panel accommodation part 110, or discharged from one side of the solar panel accommodation part 110, has a structure unfolded to be expanded to an area corresponding to one side surface among an outer peripheral surface of the vehicle after being discharged from the solar panel accommodation part 110, and may mount a plurality of solar cell panels 130 to be spaced apart from each other at predetermined intervals on one side surface.

The plurality of solar cell panels 130 according to the embodiment are configurations mounted on one side surface of the solar panel mounting part 120 to be spaced apart from each other at predetermined intervals, and may perform solar power generation.

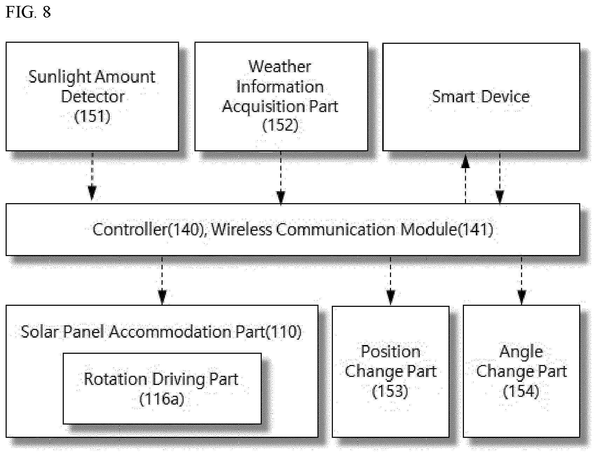

In this case, a controller (140 in FIG. 8) according to the embodiment may be mounted on the solar panel accommodation part 110, may control the operation of the solar panel accommodation part 110 according to a user's intention, and may provide electricity acquired from the solar cell panels 130 to the vehicle.

As shown in FIGS. 2, 4, and 5, the solar panel accommodation part 110 according to the present invention is a configuration including a first accommodation part 111 mounted on an upper surface of a roof of the vehicle, a second accommodation part 112 mounted on a hood upper surface of the vehicle, a third accommodation part 113 mounted on an upper surface of a rear trunk of the vehicle, fourth accommodation parts 114 mounted on side glass windows of the vehicle, and fifth accommodation parts 115 mounted on side surfaces of the vehicle.

A large vehicle shown in FIG. 4 may utilize relatively wider side surfaces compared to other vehicles, and in this case, the fifth accommodation parts 115 may be sequentially mounted adjacent to each other in an independent form by 1,000 to 1,400 mm along the side surface of the vehicle.

Further, as shown in FIG. 3, the solar cell panels 130 may be mounted in a form of which portions of both end portions are engaged with each other to overlap each other, and in this case, both end portions overlapping each other according to the user's intention may be unfolded and sequentially disposed.

Meanwhile, the solar panel mounting part 120 has a structure of which a shape is elastically deformable along the outer surface of the vehicle on which the solar panel accommodation part 110 is mounted.

In this case, according to the embodiment, it is possible to provide a vehicle including an automatic solar charging structure, which may be customized and applied to outer peripheral surfaces of all vehicles having various shapes and sizes by including the solar panel accommodation part 110 including the first accommodation part 111, the second accommodation part 112, the third accommodation part 113, the fourth accommodation parts 114, and the fifth accommodation parts 115 of specific structures, and including the solar panel mounting part 120 of which a shape is elastically deformed along the outer peripheral surfaces of the vehicle, and accordingly, may generate electricity by effectively accommodating sunlight incident on outer surfaces of the vehicle.

Meanwhile, as shown in FIG. 3, the solar panel accommodation part 110 may be a configuration including a winding roller 116 and a rotation driving part 116a having specific structures. The winding roller 116 of the solar panel accommodation part 110 may be mounted on one side surface among outer surfaces of the vehicle, and wind the solar panel mounting part 120 around an outer circumferential surface thereof to change an extending length of the solar panel mounting part 120. Further, the rotation driving part 116a of the solar panel accommodation part 110 is a configuration mounted on the winding roller 116, and may rotate the winding roller 116 according to a control signal of the controller 140.

In this case, as mentioned above, the solar panel accommodation part 110 according to the embodiment may be a configuration which winds and fixes the solar panel mounting part 120 at the outside thereof.

In this case, according to the embodiment, it is possible to provide a vehicle including an automatic solar charging structure, including a configuration capable of stably winding and store the solar cell panel 130 mounted on outer peripheral surfaces of the vehicle by including the solar panel accommodation part 110 including the winding roller 116 and the rotation driving part 116a of specific structures, and thus capable of preventing contamination of the solar cell panel 130 from an external environment.

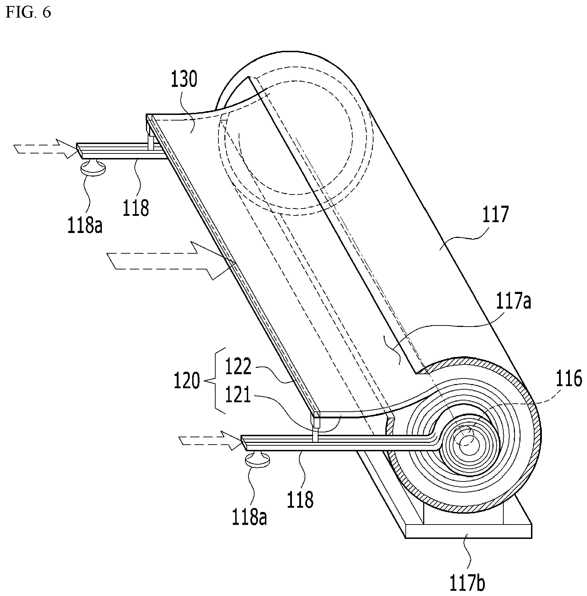

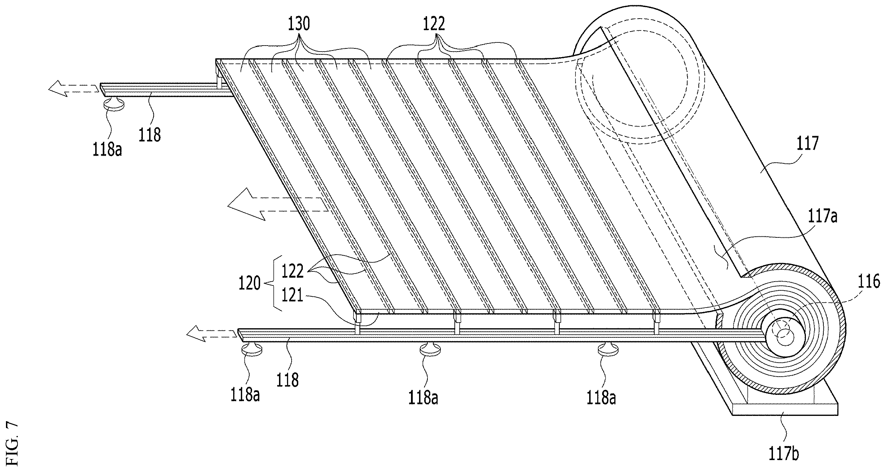

FIG. 6 is a perspective view illustrating a solar panel accommodation part, a solar panel mounting part, and a solar cell panel of a vehicle according to still another embodiment of the present invention, FIG. 7 is a perspective view illustrating a case in which the configuration shown in FIG. 6 operates, and FIG. 8 is a control block diagram illustrating a vehicle including an automatic solar charging structure according to still another embodiment of the present invention.

Referring to these drawings, the solar panel accommodation part 110 according to the embodiment may be a configuration including a winding housing 117, a housing fixing part 117b, a winding roller 116, a rotation driving part 116a, extending rails 118, and detachable fixing parts 118a of specific structures.

Specifically, the winding housing 117 of the solar panel accommodation part 110 is a configuration mounted on one side surface among outer surfaces of the vehicle, and may have a hollow-type cylindrical structure in which the winding roller 116 is rotatably mounted therein and a discharge port 117a through which the solar panel mounting part 120 accommodated therein may enter and exit is formed on one side surface.

The housing fixing part 117b may be a configuration mounted on one side surface of the winding housing 117, and may have a structure which detachably fixes the winding housing 117 to the outer surface of the vehicle
The winding roller 116 may have a structure which is rotatably mounted in the winding housing, and winds the solar panel mounting part 120 around an outer circumferential surface thereof
In this case, the rotation driving part 116a mounted on one side of the winding housing 117 may rotate the winding roller 116 according to a control signal of the controller 140.

A pair of extending rails 118 may be a configuration mounted in a state of being adjacent to the discharge port 117a formed at one side of the solar panel accommodation part 110 and being wound at both side surfaces, and may have a structure that is drawn out by a user to extend by a predetermined length in a discharging direction of the solar panel mounting part 120.

Further, the detachable fixing parts 118a may be a configuration mounted at one sides of the extending rails 118 to be spaced apart from each other at a predetermined interval, and may adsorb and fix the extending rails 118 to the outer surface of the vehicle.

Meanwhile, the solar panel mounting part 120 according to the embodiment may be a configuration including extending frames 121 and spacing frames 122 of specific structures.

Specifically, a pair of extending frames 121 may have a wire structure that is wound around outer circumferential surfaces of both end portions of the winding roller 116 or a flexible bar structure, and a structure of which a position is changed along the extending rails 118, and may be bound to both end portions of the solar cell panel 130 to fix a position of the solar cell panel 130.

In this case, the spacing frames 122 may be a configuration mounted between the pair of extending frames 121 in an integrated structure, and may have a structure which maintains an interval between the pair of extending frames 121 at a predetermined distance. In some cases, the spacing frames 122 may be a configuration including a variable structure of which a length may be changed according to the user's intention.

In this case, according to the embodiment, it is possible to provide a vehicle including an automatic solar charging structure, including a configuration capable of stably winding and store the solar cell panel 130 mounted on outer peripheral surfaces of the vehicle by including the solar panel accommodation part 110 including the winding housing 117, the housing fixing part 117b, the winding roller 116, the rotation driving part 116a, the extending rails 118, and the detachable fixing part 118a of specific structures, and the solar panel mounting part 120 including the extending frames 121 and the spacing frames 122 of specific structures to prevent contamination of the solar cell panel 130 from an external environment.

FIG. 8 is a control block diagram illustrating a vehicle including an automatic solar charging structure according to still another embodiment of the present invention.

Referring to FIG. 8 together with FIGS. 6 and 7, a vehicle 100 according to the embodiment may be a configuration further including a sunlight amount detector 151, a weather information acquisition part 152, a position change part 153, and an angle change part 154 which perform specific roles.

Specifically, the sunlight amount detector 151 of the vehicle according to the embodiment may be a configuration mounted on the outer surface of the vehicle to detect an amount of sunlight incident thereon in real time, and transmit detected data to the controller.

The weather information acquisition part 152 may be a configuration mounted in the vehicle, and may be linked to an Internet network to receive real-time weather information and transmit the real-time weather information to the controller 140.

The position change part 153 may be a configuration mounted on the outer surface of the vehicle, and may change a position of the solar panel accommodation part 110.

Further, the angle change part 154 may change a mounting angle of the solar cell panel 130 mounted on the solar panel mounting part 120.

In this case, the controller 140 according to the embodiment may control operations of the solar panel accommodation part 110, the position change part 153, and the angle change part 154 using the sunlight amount detector 151 and the weather information acquisition part 152.

Further, the controller 140 according to the embodiment may be a configuration in which there is a built-in wireless communication module 141 interworking with a user's smart device, and may provide an operation state of the solar panel accommodation part 110 and a production state of electricity produced from the solar cell panels 130 to the user's smart device using the wireless communication module 141.

In this case, according to the embodiment, it is possible to provide a vehicle including an automatic solar charging structure, capable of controlling the solar panel accommodation part 110, the position change part 153, and the angle change part 154 using the sunlight amount detector 151 and the weather information acquisition part 152, capable of providing an operation state of the solar panel accommodation part 110 and a production state of electricity produced from the solar cell panels 130 to the user's smart device using the wireless communication module 141 by including the sunlight amount detector and the weather information acquisition part which perform specific roles, and the controller 140 which performs specific control, and thus capable of significantly improving solar power generation efficiency by actively changing the structure according to a weather condition.

As described above, according to a vehicle including an automatic solar charging structure of the present invention, it is possible to provide a vehicle including an automatic solar charging structure including a configuration capable of effectively accommodating solar energy to efficiently produce electric energy, and capable of cleanly protecting a solar cell panel to stably maintain power generation efficiency using the solar energy by including a solar panel accommodation part, a solar panel mounting part, a solar cell panel and a controller of specific structures.

Further, according to the vehicle including an automatic solar charging structure of the present invention, it is possible to provide a vehicle including an automatic solar charging structure, which can be customized and applied to outer peripheral surfaces of all vehicles having various shapes and sizes by including a solar panel accommodation part including a first accommodation part, a second accommodation part, a third accommodation part, a fourth accommodation part, and a fifth accommodation part of specific structures, and including a solar panel mounting part of which a shape is elastically deformed along an outer peripheral surfaces of the vehicle, and accordingly, can generate electricity by effectively accommodating sunlight incident on outer surfaces of the vehicle.

In addition, according to the vehicle including an automatic solar charging structure of the present invention, it is possible to provide a vehicle including an automatic solar charging structure, including a configuration capable of stably winding and store a solar cell panel mounted on outer peripheral surfaces of the vehicle by including a solar panel accommodation part including a winding roller and a rotation driving part of specific structures to prevent contamination of the solar cell panel from an external environment.

In addition, according to the vehicle including an automatic solar charging structure of the present invention, it is possible to provide a vehicle including an automatic solar charging structure, including a configuration capable of stably winding and store a solar cell panel mounted on outer peripheral surfaces of the vehicle by including a solar panel accommodation part including a winding housing, a housing fixing part, a winding roller, a rotation driving part, extending rails, and detachable fixing parts of specific structures, and a solar panel mounting part including extending frames and spacing frames of specific structures to prevent contamination of the solar cell panel from an external environment.

In addition, according to the vehicle including an automatic solar charging structure of the present invention, it is possible to provide a vehicle including an automatic solar charging structure, capable of controlling operations of a solar panel accommodation part, a position change part, and an angle change part using a sunlight amount detector and a weather information acquisition part, and capable of providing an operation state of the solar panel accommodation part and a production state of electricity produced from the solar cell panels to a user's smart device using a wireless communication module by including the sunlight amount detector and the weather information acquisition part which perform specific roles, and a controller which performs specific control to significantly improve solar power generation efficiency by actively changing the structure according to a weather condition.

In the above detailed description of the present invention, only specific embodiments thereof have been described. However, it should be understood that the present invention is not limited to specific forms mentioned in the detailed description, but includes all modifications, equivalents, and substitutions within the scope of the present invention defined by the appended claims.

That is, the present invention is not limited to the above-described specific embodiments and descriptions, and various modifications may be performed by those skilled in the art without departing from the scope defined in the claims.

## Claims

1. A vehicle comprising:
a solar panel accommodation part (110) mounted on one side surface among outer surfaces of the vehicle to wind and accommodate a solar panel mounting part (120);
the solar panel mounting part (120) having a structure that is inserted into and accommodated in the solar panel accommodation part (110) or discharged from one side of the solar panel accommodation part (110), having a structure that is unfolded to be expanded to an area corresponding to one side surface among an outer peripheral surface of the vehicle after being discharged from the solar panel accommodation part (110), and configured to mount a plurality of solar cell panels (130) to be spaced apart from each other at predetermined intervals on one side surface;
the solar cell panels (130) mounted on the one side surface of the solar panel mounting part (120) to be spaced apart from each other at the predetermined intervals, and configured to perform solar power generation; and
a controller (140) mounted on the solar panel accommodation part (110), configured to control an operation of the solar panel accommodation part (110) according to a user's intention, and providing electricity acquired from the solar cell panels (130) to the vehicle, wherein the solar panel accommodation part (110) includes:
a first accommodation part (111) mounted on an upper surface of a roof of the vehicle; and a second accommodation part (112) mounted on a hood upper surface of the vehicle,
**characterized in that** the solar panel accommodation part (110) further includes:
a third accommodation part (113) mounted on an upper surface of a rear trunk of the vehicle; fourth accommodation parts (114) mounted on side glass windows of the vehicle; and fifth accommodation parts (115) mounted on side surfaces of the vehicle; and
the solar panel mounting part (120) has a structure of which a shape is elastically deformable along the outer surface of the vehicle on which the solar panel accommodation part (110) is mounted.

2. The vehicle of claim 1, wherein the solar panel accommodation part (110) includes:
a winding housing (117) of a hollow-type cylindrical structure that is mounted on the one side surface among the outer surfaces of the vehicle, configured to rotatably mount a winding roller (116) therein, and formed with a discharge port (117a) through which the solar panel mounting part (120) accommodated therein enters and exits at one side surface;
a housing fixing part (117b) having a structure that is mounted on one side surface of the winding housing (117), and configured to detachably fix the winding housing (117) to the outer surface of the vehicle;
the winding roller (116) rotatably mounted in the winding housing, and configured to wind the solar panel mounting part (120) around an outer circumferential surface thereof;
a rotation driving part (116a) mounted at one side of the winding housing (117) and configured to rotate the winding roller (116) according to a control signal of the controller (140);
a pair of extending rails (118) having a structure that is mounted in a state of being adjacent to the discharge port (117a) formed at one side of the solar panel accommodation part (110) and being wound at both side surfaces, and drawn out by a user to extend by a predetermined length in a discharging direction of the solar panel mounting part (120); and
a plurality of detachable fixing parts (118a) mounted at one sides of the extending rails (118) to be spaced apart from each other at a predetermined interval, and configured to adsorb and fix the extending rails (118) to the outer surface of the vehicle, and
the solar panel mounting part (120) includes:
a pair of extending frames (121) having a wire structure that is wound around outer circumferential surfaces of both end portions of the winding roller (116), having a structure of which a position is changed along the extending rails (118), and bound to both end portions of the solar cell panel (130) to fix a position of the solar cell panel (130); and
spacing frames (122) mounted between the pair of extending frames (121) in an integrated structure, and configured to maintain an interval between the pair of extending frames (121) at a predetermined distance.

3. The vehicle of claim 1, wherein the fifth accommodation parts (115) of the solar panel accommodation part (110) are sequentially mounted to be adjacent to each other in an independent form by 1,000 to 1,400 mm along the side surface of the vehicle,
the solar cell panels (130) are mounted in a form of which portions of both end portions are engaged with each other to overlap each other, and
both end portions of the solar cell panels (130) overlapping each other according to the user's intention are unfolded and sequentially disposed.

4. The vehicle of claim 1, wherein the vehicle includes:
a sunlight amount detector (151) mounted on the outer surface of the vehicle to detect an amount of sunlight incident thereon in real time, and transmit detected data to the controller;
a weather information acquisition part (152) mounted in the vehicle and linked to an Internet network to receive real-time weather information and transmit the real-time weather information to the controller (140);
a position change part (153) mounted on the outer surface of the vehicle, and configured to change a position of the solar panel accommodation part (110); and
an angle change part (154) configured to change a mounting angle of the solar cell panels (130) mounted on the solar panel mounting part (120), and
the controller (140) controls operations of the solar panel accommodation part (110), the position change part (153), and the angle change part (154) using the sunlight amount detector (151) and the weather information acquisition part (152), has a built-in wireless communication module (141) interworking with a user's smart device, and provides an operation state of the solar panel accommodation part (110) and a production state of electricity produced from the solar cell panels (130) to the user's smart device using the wireless communication module (141).

## Patentansprüche

1. Fahrzeug, aufweisend:
ein Solarpanel-Aufnahmeteil (110), welches an einer Seitenfläche von Außenflächen des Fahrzeugs angebracht ist, um ein Solarpanel-Befestigungsteil (120) aufzuwickeln und aufzunehmen;
das Solarpanel-Befestigungsteil (120), welches einen Aufbau hat, welcher in das Solarpanel-Aufnahmeteil (110) hinein eingesetzt und darin aufgenommen ist oder von einer Seite des Solarpanel-Aufnahmeteils (110) aus herausgelassen ist, einen Aufbau hat, welcher entfaltet ist, um sich zu einer Fläche zu erstrecken, welche mit einer Seitenfläche von einer Außenumfangsfläche des Fahrzeugs korrespondiert, nachdem es aus dem Solarpanel-Aufnahmeteil (110) herausgelassen worden ist, und konfiguriert ist, um mehrere Solarzellenpanels (130) zu montieren, welche an einer Seitenfläche in vorbestimmten Abständen voneinander beabstandet sein sollen;
die Solarzellenpanels (130), welche an der einen Seitenfläche von dem Solarpanel-Befestigungsteil (120) montiert sind, um in den vorbestimmten Abständen voneinander beabstandet zu sein, und konfiguriert sind, um Solarenergieerzeugung durchzuführen; und
eine Steuervorrichtung (140), welche an dem Solarpanel-Aufnahmeteil (110) montiert ist, konfiguriert ist, um einen Betrieb des Solarpanel-Aufnahmeteils (110) gemäß einer Benutzerabsicht zu steuern, und dem Fahrzeug elektrischen Strom bereitstellt, welcher von den Solarzellenpanels (130) aus erlangt wurde, wobei das Solarpanel-Aufnahmeteil (110) aufweist:
ein erstes Aufnahmeteil (111), welches an einer oberen Fläche eines Daches des Fahrzeugs montiert ist; und
ein zweites Aufnahmeteil (112), welches an einer oberen Fläche einer Motorhaube des Fahrzeugs montiert ist,
**dadurch gekennzeichnet, dass** das Solarpanel-Aufnahmeteil (110) ferner aufweist:
ein drittes Aufnahmeteil (113), welches an einer oberen Fläche eines hinteren Kofferraums des Fahrzeugs montiert ist; vierte Aufnahmeteile (114), welche an Seitenglasfenstern des Fahrzeugs montiert sind; und fünfte Aufnahmeteile (115), welche an Seitenflächen des Fahrzeugs montiert sind; und
wobei das Solarpanel-Befestigungsteil (120) einen Aufbau hat, von welchem eine Form entlang der Außenfläche des Fahrzeugs, an welcher das Solarpanel-Aufnahmeteil (110) montiert ist, elastisch verformbar ist.

2. Fahrzeug gemäß Anspruch 1, wobei das Solarmodul-Aufnahmeteil (110) aufweist:
ein Wickelgehäuse (117) von einem hohlzylindrischen Aufbau, welches an der einen Seitenfläche von den Außenflächen des Fahrzeugs montiert ist, konfiguriert ist, um eine Wickelrollvorrichtung (116) darin drehbar zu montieren, und mit einer Auslassöffnung (117a) gebildet ist, durch welche das Solarpanel-Befestigungsteil (120), welches darin aufgenommen ist, an einer Seitenfläche eintritt und austritt;
ein Gehäusefixierungsteil (117b), welches einen Aufbau hat, welcher an einer Seitenfläche des Wickelgehäuses (117) montiert ist, und konfiguriert ist, um das Wickelgehäuse (117) abnehmbar an der Außenfläche des Fahrzeugs zu fixieren;
wobei die Wickelrollvorrichtung (116) drehbar in dem Wickelgehäuse montiert ist, und konfiguriert ist, um das Solarpanel-Befestigungsteil (120) um eine äußere Umfangsfläche davon herum zu wickeln;
ein Drehantriebsteil (116a), welches an einer Seite des Wickelgehäuses (117) montiert ist und konfiguriert ist, um die Wickelrollvorrichtung (116) gemäß einem Steuersignal der Steuervorrichtung (140) zu drehen;
ein Paar von Verlängerungsschienen (118), welche einen Aufbau haben, welcher in einem Zustand des zu der Auslassöffnung (117a), welche an einer Seite von dem Solarpanel-Aufnahmeteil (110) gebildet ist, Benachbart-Seiens montiert ist und an beiden Seitenflächen gewickelt ist, und von einem Benutzer herausgezogen werden, um sich um eine vorbestimmte Länge in einer Auslassrichtung des Solarpanel-Befestigungsteil (120) zu erstrecken; und
mehrere abnehmbare Fixierungsteile (118a), welche an jeweils einer Seite der Verlängerungsschienen (118) angebracht sind, um in einem vorbestimmten Abstand voneinander beabstandet zu sein, und konfiguriert sind, um die Verlängerungsschienen (118) an der Außenfläche des Fahrzeugs aufzunehmen und zu fixieren, und
wobei das Solarpanel-Befestigungsteil (120) aufweist:
ein Paar von Verlängerungsrahmen (121), welche einen Drahtaufbau haben, welcher um die Außenumfangsflächen beider Endabschnitte der Wickelrollvorrichtung (116) gewickelt ist, einen Aufbau haben, von welchem eine Position entlang der Verlängerungsschienen (118) geändert wird, und mit beiden Endabschnitten der Solarzellenpanels (130) verbunden sind, um eine Position des Solarzellenpanels (130) zu fixieren; und
Abstandsrahmen (122), welche zwischen dem Paar von Verlängerungsrahmen (121) in einem integrierten Aufbau montiert sind, und konfiguriert sind, um einen Abstand zwischen dem Paar von Verlängerungsrahmen (121) bei einer vorbestimmten Entfernung zu halten.

3. Fahrzeug gemäß Anspruch 1, wobei die fünften Aufnahmeteile (115) des Solarpanel-Aufnahmeteils (110) aufeinanderfolgend so montiert sind, dass sie in einer unabhängigen Form um 1.000 bis 1.400 mm entlang der Seitenfläche des Fahrzeugs zueinander benachbart sind,
wobei die Solarzellenpanels (130) in einer Form montiert sind, von welcher Abschnitte von beiden Endabschnitten miteinander in Eingriff stehen, um einander zu überlappen, und
wobei beide Endabschnitte der einander überlappenden Solarzellenpanels (130) gemäß Benutzerabsicht entfaltet sind und aufeinanderfolgend angeordnet sind.

4. Fahrzeug gemäß Anspruch 1, wobei das Fahrzeug aufweist:
einen Sonnenlichtmengendetektor (151), welcher an der Außenfläche des Fahrzeugs montiert ist, um eine Menge von darauf einfallendem Sonnenlicht in Echtzeit zu erfassen und die erfassten Daten an die Steuervorrichtung zu übertragen;
ein Wetterinformationserlangungsteil (152), welches in dem Fahrzeug montiert und mit einem Internet-Netzwerk verbunden ist, um Echtzeit-Wetterinformationen zu empfangen und die Echtzeit-Wetterinformationen an die Steuervorrichtung (140) zu übertragen;
ein Positionsänderungsteil (153), welches an der Außenfläche des Fahrzeugs montiert ist und konfiguriert ist, um eine Position des Solarpanel-Aufnahmeteils (110) zu ändern; und
ein Winkeländerungsteil (154), welches konfiguriert ist, um einen Montagewinkel der Solarzellenpanels (130), welche an dem Solarpanel-Befestigungsteil (120) montiert sind, zu ändern, und
wobei die Steuervorrichtung (140) Vorgänge des Solarzellenpanel-Aufnahmeteils (110), des Positionsänderungsteils (153) und des Winkeländerungsteils (154) unter Verwendung des Sonnenlichtmengendetektors (151) und des Wetterinformationserlangungsteils (152) steuert, ein eingebautes Drahtlose-Kommunikation-Modul (141) hat, welches mit einem Benutzer-Smart-Gerät zusammenarbeitet, und dem Benutzer-Smart-Gerät einen Betriebszustand des Solarpanel-Aufnahmeteils (110) und einen Erzeugungszustand von elektrischem Strom bereitstellt, welcher von den Solarzellenpanels (130) erzeugt wird, unter Verwendung des Drahtlose-Kommunikation-Moduls (141).

## Revendications

1. Véhicule, comprenant :
une partie de logement de panneau solaire (110) montée sur une surface latérale parmi des surfaces extérieures du véhicule pour enrouler et loger une partie de montage de panneau solaire (120) ;
la partie de montage de panneau solaire (120) ayant une structure qui est insérée et logée dans la partie de logement de panneau solaire (110) ou déchargée d'un côté de la partie de logement de panneau solaire (110), ayant une structure qui est dépliée pour être étendue à une zone correspondant à une surface latérale parmi une surface périphérique extérieure du véhicule après avoir été déchargée de la partie de logement de panneau solaire (110), et configurée pour monter une pluralité de panneaux de cellules solaires (130) pour être espacés les uns des autres à des intervalles prédéterminés sur une surface latérale ;
les panneaux de cellules solaires (130) montés sur ladite une surface latérale de la partie de montage de panneau solaire (120) pour être espacés les uns des autres à des intervalles prédéterminés, et configurés pour effectuer une production d'énergie solaire ; et
un contrôleur (140) monté sur la partie de logement de panneau solaire (110), configuré pour contrôler un fonctionnement de la partie de logement de panneau solaire (110) en fonction d'une intention d'utilisateur, et fournissant au véhicule de l'électricité acquise des panneaux solaires (130), dans lequel la partie de logement de panneau solaire (110) comprend :
une première partie de logement (111) montée sur une surface supérieure d'un toit du véhicule ; et une deuxième partie de logement (112) montée sur une surface supérieure de capot du véhicule,
**caractérisé en ce que** la partie de logement de panneau solaire (110) comprend en outre :
une troisième partie de logement (113) montée sur une surface supérieure d'un coffre arrière du véhicule ; des quatrièmes parties de logement (114) montées sur des vitres latérales du véhicule ; et des cinquièmes parties de logement (115) montées sur des surfaces latérales du véhicule ; et
la partie de montage de panneau solaire (120) a une structure dont une forme est élastiquement déformable le long de la surface extérieure du véhicule sur laquelle la partie de logement de panneau solaire (110) est montée.

2. Véhicule selon la revendication 1, dans lequel la partie de logement de panneau solaire (110) comprend :
un boîtier d'enroulement (117) d'une structure cylindrique de type creux qui est monté sur ladite une surface latérale parmi les surfaces extérieures du véhicule, configuré pour monter de manière rotative un rouleau d'enroulement (116) à son intérieur, et formé avec un orifice de décharge (117a) à travers lequel la partie de montage de panneau solaire (120) logée à son intérieur entre et sort sur une surface latérale ;
une partie de fixation de boîtier (117b) ayant une structure qui est montée sur une surface latérale du boîtier d'enroulement (117) et configurée pour fixer de manière amovible le boîtier d'enroulement (117) à la surface extérieure du véhicule ;
le rouleau d'enroulement (116) monté de manière rotative dans le boîtier d'enroulement et configuré pour enrouler la partie de montage de panneau solaire (120) autour d'une surface circonférentielle extérieure de celui-ci ;
une partie d'entraînement de rotation (116a) montée sur un côté du boîtier d'enroulement (117) et configurée pour faire tourner le rouleau d'enroulement (116) en fonction d'un signal de commande du contrôleur (140) ;
une paire de rails d'extension (118) ayant une structure qui est montée dans un état adjacent à l'orifice de décharge (117a) formé sur un côté de la partie de logement de panneau solaire (110) et étant enroulée sur les deux surfaces latérales, et tirée par un utilisateur pour s'étendre sur une longueur prédéterminée dans une direction de décharge de la partie de montage de panneau solaire (120) ; et
une pluralité de parties de fixation amovibles (118a) montées respectivement sur un côté des rails d'extension (118) pour être espacées les unes des autres à un intervalle prédéterminé, et configurées pour absorber et fixer les rails d'extension (118) à la surface extérieure du véhicule, et
la partie de montage de panneau solaire (120) comprend :
une paire de cadres d'extension (121) ayant une structure de fil qui est enroulée autour de surfaces circonférentielles extérieures des deux parties d'extrémité du rouleau d'enroulement (116), ayant une structure dont une position est modifiée le long des rails d'extension (118), et liée aux deux parties d'extrémité du panneau de cellules solaires (130) pour fixer une position du panneau de cellules solaires (130) ; et
des cadres d'espacement (122) montés entre la paire de cadres d'extension (121) dans une structure intégrée, et configurés pour maintenir un intervalle entre la paire de cadres d'extension (121) à une distance prédéterminée.

3. Véhicule selon la revendication 1, dans lequel les cinquièmes parties de logement (115) de la partie de logement de panneau solaire (110) sont montées séquentiellement pour être adjacentes les unes aux autres dans une forme indépendante de 1000 à 1400 mm le long de la surface latérale du véhicule,
les panneaux de cellules solaires (130) sont montés sous une forme dont des parties des deux parties d'extrémité sont en prise l'une avec l'autre pour se chevaucher, et
les deux parties d'extrémité des panneaux de cellules solaires (130) se chevauchant l'une l'autre selon l'intention de l'utilisateur sont dépliées et disposées de manière séquentielle.

4. Véhicule selon la revendication 1, dans lequel le véhicule comprend :
un détecteur de quantité de lumière solaire (151) monté sur la surface extérieure du véhicule pour détecter une quantité de lumière solaire incidente en temps réel, et transmettre des données détectées au contrôleur ;
une partie d'acquisition d'informations météorologiques (152) montée dans le véhicule et reliée à un réseau Internet pour recevoir des informations météorologiques en temps réel et transmettre les informations météorologiques en temps réel au contrôleur (140) ;
une partie de changement de position (153) montée sur la surface extérieure du véhicule et configurée pour changer une position de la partie de logement de panneau solaire (110) ; et
une partie de changement d'angle (154) configurée pour changer un angle de montage des panneaux de cellules solaires (130) montés sur la partie de montage de panneau solaire (120), et
le contrôleur (140) commande des opérations de la partie de logement de panneau solaire (110), de la partie de changement de position (153) et de la partie de changement d'angle (154) en utilisant le détecteur de quantité de lumière solaire (151) et la partie d'acquisition d'informations météorologiques (152), possède un module de communication sans fil intégré (141) fonctionnant avec un dispositif intelligent d'un utilisateur, et fournit un état de fonctionnement de la partie de logement de panneau solaire (110) et un état de production d'électricité produite à partir des panneaux de cellules solaires (130) au dispositif intelligent de l'utilisateur en utilisant le module de communication sans fil (141).
